# EUROPÄISCHE PATENTSCHRIFT

(11) **EP 1 193 552 B1**
(45) Veröffentlichungstag und Bekanntmachung des Hinweises auf die Patenterteilung: **20.06.2012**
(21) Anmeldenummer: 01118800.0
(22) Anmeldetag: 09.08.2001
(51) Int. Cl.: G03F 1/70, G03F 1/00

(54) **Verfahren zum Erzeugen von Masken-Layout-Daten für die Lithografiesimulation und von optimierten Masken-Layout-Daten**
Process for establishing mask lay-out data for simulating a lithographic process and for defining an optimized mask lay-out data
Procédé pour établir des données de masque pour la simulation lithographique ainsi que pour réaliser un lay-out de masque optimalisé

(30) Priorität: 07.09.2000 DE 10044257
(43) Veröffentlichungstag der Anmeldung: 03.04.2002
(73) Patentinhaber: Qimonda AG, 81739 München (DE)
(72) Erfinder: Semmler, Armin, Dr., 80639 München (DE); Haffner, Henning, 01099 Dresden (DE); Friedrich, Christoph, 80637 München (DE)
(74) Vertreter: Isarpatent

(56) Entgegenhaltungen:
- JP-A- 9 034 101
- US-A- 5 278 421
- US-A- 5 657 235
- US-A- 5 698 346
- US-A- 5 991 006
- US-A- 6 044 007
- US-A- 6 081 658
- OHNUMA H ET AL: "FAST CHIP LEVEL OPC METHOD ON MASK DATABASE" PROCEEDINGS OF THE SPIE, SPIE, BELLINGHAM, VA, US, Bd. 3096, 1997, Seiten 145-153, XP000933786 ISSN: 0277-786X

## Beschreibung

Die Erfindung betrifft ein Verfahren zum Erzeugen von Masken-Layout-Daten für die Simulation eines Lithografie-Verfahrens. Es werden Ursprungsdaten vorgegeben, die ein Ursprungs-Layout festlegen. Ausgehend von den Ursprungs-Daten werden automatisch neue Daten berechnet. Die Berechnung erfolgt so, dass ein durch die neuen Daten festgelegtes neues Masken-Layout hinsichtlich der Geometrie einer mit den Ursprungsdaten herstellbaren oder hergestellten Maske ähnlicher als dem Ursprungs-Layout ist.

Die japanische Patentschrift JP 9034101 beschreibt ein Verfahren zum Erzeugen von optimierten Masken-Layout-Daten für Fotomasken, bei dem Ursprungs-Daten vorgegeben werden, welche ein gewünschtes Layout festlegen. Ausgehend von den Ursprungs-Daten werden an Ecken Dreiecke nach vorgegebenen Regeln hinzugefügt bzw. entfernt. Ist ein Layout hinsichtlich der Geometrie mit der so abgeänderten Maske dem Ursprungs-Layout ähnlicher, als ohne entsprechende Änderungen, wird die neue Maske als Foto-Lack-Maske verwendet. Eine Simulation der geänderten Maske erfolgt mittels einer Lichtbeugungstheorie. US-Patentschrift 6,044,007 offenbart ein Verfahren zum Ändern von Masken-Layout-Daten, um eine Abbildung eines gewünschten Layouts zu verbessern. Dazu werden Abmessungen eines Ursprungs-Layouts mittels Anpassungsstücken verändert.

US-Patentschrift US 6,261,724B1 offenbart ein Verfahren zur Bestimmung von optimierten Masken-Layouts durch Simulation der Abbildung durch die Maske an inneren und äußeren Ecken der Maskenstrukturen.

Bei einem mit Hilfe des Programms "Selid" der Firma Sigma-C durchgeführten bekannten Verfahren werden die aufeinanderfolgenden Schritte des Herstellungsprozesses zur Herstellung einer Fotomaske physikalisch nachgebildet, z.B. Schreiben der Maske auf ein Fotoresist mittels Laser- oder Elektronenstrahlschreiber, Entwickeln des Fotoresists und Ätzen der Maske. Unter anderem werden dabei Reaktionsdiffusionsprozesse nachgebildet. Das Nachbilden des Herstellungsprozesses der Maske erfordert ein zusätzliches Programm, das sich vom später genutzten Programm zur Nachbildung des Belichtungsund Lackentwicklungsprozesses eines Wafers unterscheidet. Für das zusätzliche Programm sind zusätzliche Eingangsparameter erforderlich, die zum Teil aufwendig experimentell bestimmt werden müssen. Die Nachbildung der Schritte des Herstellungsprozesses erfordert deshalb zusätzlichen Zeit- und Rechenaufwand sowie außerdem eine hohe Rechenleistung.

Es ist Aufgabe der Erfindung, zum Erzeugen von Masken-Layout-Daten für Lithografie-Masken ein einfaches Verfahren anzugeben, bei dem das neue Layout bei verringertem Aufwand einer mit den Ursprungsdaten hergestellten Maske weiterhin sehr ähnlich ist.

Die das Verfahren betreffende Aufgabe wird durch ein Verfahren mit den im Patentanspruch 1 angegebenen Verfahrensschritten gelöst. Weiterbildungen sind in den Unteransprüchen angegeben.

Die Erfindung geht von der Erkenntnis aus, dass Abweichungen einer durch ein Layout festgelegten Maske von einer nach diesem Layout hergestellten bzw. einer ausgehend von diesem Layout unter Nachbildung des Herstellungsprozesses modellierten Maske auf den Herstellungsprozess zurückzuführen sind. Diese Abweichungen hängen von der Geometrie der herzustellenden Maske ab und lassen sich bereits aufgrund der Geometrie des Ursprungs-Layouts weitgehend vorausbestimmen. Dies ermöglicht es, eine Nachbildung der einzelnen Schritte des Herstellungsprozesses zu vermeiden und dennoch die Einflüsse des Herstellungsprozesses auf die Geometrie schnell und ohne großen Aufwand zu berücksichtigen.

Beim erfindungsgemäßen Verfahren werden zusätzlich zu den eingangs genannten Verfahrensschritten die neuen Daten, die für die Lithografiesimulation eingesetzt werden sollen, aufgrund von Regeln berechnet, die auf Abweichungen in der Geometrie eines Layouts von einer nach diesem Layout hergestellten Maske beruhen. Alternativ zur Herstellung lässt sich die zum Vergleich herangezogene Maske auch ausgehend von dem Layout unter Nachbildung der Schritte des Herstellungsprozesses modellieren. In beiden Fällen werden beim erfindungsgemäßen Verfahren die einzelnen Verfahrensschritte des Kerstellungsprozesses der Maske bei der Berechnung der neuen Daten jedoch nicht nachgebildet. Die Eingabe einer Vielzahl von Prozessparametern für die Nachbildung des Herstellungsprozesses und die rechenaufwendige Nachbildung selbst entfallen damit.

Die Abweichungen in der Geometrie lassen sich durch einfache geometrische Zusammenhänge berechnen. Differenzialgleichungen, wie z.B. Diffusionsgleichungen, sind nicht zu lösen. Dadurch lassen sich die neuen Masken-Daten mit einem im Vergleich zur Nachbildung des Herstellungsprozesses um Größenordnungen verringerten Rechenaufwand berechnen.

Bei dem erfindungsgemäßen Verfahren sind die Regeln geometrische Berechnungsvorschriften zum Festlegen der Grenzen einer Struktur an einer Position des neuen Layouts abhängig von der Länge und/oder der Fläche einer an der gleichen Position in dem Ursprungs-Layout liegenden Bezugsstruktur. Alternativ oder kumulativ wird auch der Abstand der Bezugsstruktur zu den benachbarten Strukturen des Ursprungs-Layouts in die Berechnungsvorschrift einbezogen. Die Länge und die Fläche einer Struktur bestimmen das Maß der zu ermittelnden Abweichungen. Die benachbarten Strukturen erlauben Rückschlüsse darauf, an welchen Stellen Abweichungen auftreten werden. Während des Maskenschreibprozesses von eng benachbarten Strukturen treten nämlich andere Effekte auf als beim Schreiben von benachbarten Strukturen mit größerem Abstand zur Bezugsstruktur.

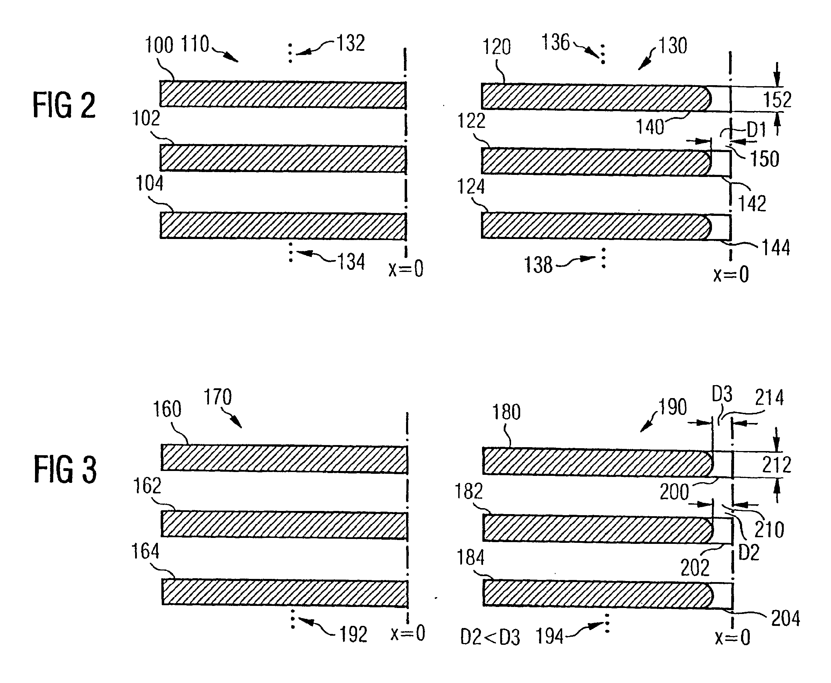

Bei einer Ausgestaltung wird gemäß einer Regel ein Verkürzungswert für eine langgestreckte Bezugsstruktur, die auch als Linienstruktur oder kurz als Linie bezeichnet wird, an einer Position des Ursprungs-Layouts ermittelt. Abhängig vom Verkürzungswert wird die an der gleichen Position in dem neuen Layout liegende Struktur im Vergleich zur Bezugsstruktur in Längsrichtung verkürzt. Die Linienverkürzung lässt sich auf das Fehlen von Nachbarstrukturen zurückführen. Damit ist die Art der Linienverkürzung und das Maß der Linienverkürzung aufgrund der Geometrie des Ursprungs-Layouts bestimmbar. Linienverkürzungen sind in den Figuren 2 bis 4 dargestellt, die unten näher erläutert werden.

Bei einer anderen Ausgestaltung wird gemäß einer weiteren Regel eine eckige Bezugsstruktur an einer Position des Ursprungs-Layouts ermittelt. Eine Ecke lässt sich mit Hilfe des Winkels zwischen zwei aufeinandertreffenden Linien bzw. geraden Kanten definieren. Die Strukturen haben bei einem üblichen Entwurf oft Ecken, deren Kanten in einem Winkel von 90° zueinander stehen (es sind aber auch beliebige Winkel denkbar) . Zum Abrunden einer Ecke wird mindestens ein Radius-oder Krümmungswert ermittelt oder durch eine Bedienperson eingegeben. Abhängig vom Radius- oder Krümmungswert werden die neuen Daten so berechnet, dass die an der gleichen Position in dem neuen Layout liegende Struktur anstelle der Ecke einen abgerundeten Kantenverlauf hat. Der Radiuswert lässt sich beispielsweise direkt aus der Breite einer Struktur ermitteln. Zur Berechnung der Lage der Struktur in dem neuen Layout lässt sich dann beispielsweise die Kreisgleichung verwenden. Eckenabrundungen werden unten an Hand der Figuren 2 bis 5 erläutert.

Bei einer Ausgestaltung wird der Radius abhängig vom Umfeld gewählt. Bei einer Licht absorbierenden Struktur, die um eine lichtdurchlässige Struktur herum angeordnet ist, wird eine innen liegende Ecke mit einem kleineren Radius abgerundet, als eine außen liegende Ecke der Licht absorbierenden Struktur.

Bei einer weiteren Ausgestaltung wird gemäß einer Regel ein Einengungswert für eine langgestreckte Bezugsstruktur an einer Position des Ursprung-Layouts ermittelt. Abhängig vom Einengungswert wird dann die an der gleichen Position in dem neuen Layout liegende Struktur im Vergleich zur Bezugsstruktur zumindest abschnittsweise quer zur Längsrichtung eingeengt. Durch diese Maßnahme wird der sogenannte "Peanuts"-Effekt berücksichtigt, weil Einengungen von Strukturen nachgebildet werden, die auf das Fehlen von benachbarten Strukturren während der Herstellung der Maske zurückzuführen sind.

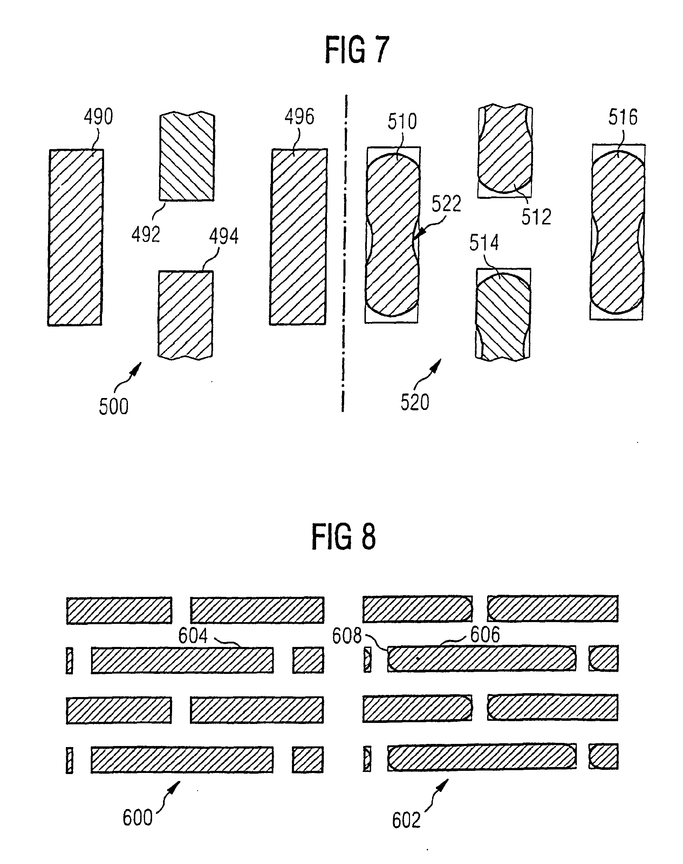

Der "Peanuts"-Effekt wird unten an Hand der Figur 7 erläuterm

Die Erfindung betrifft in einem zweiten Aspekt ein Verfahren zum Erzeugen von optimierten Masken-Layout-Daten für Fotomasken. Bei dem Verfahren gemäß zweitem Aspekt werden wieder Ursprungsdaten vorgegeben, die ein Ursprungs-Layout für die Simulation eines Lithografie-Verfahrens festlegen. Ausgehend von den Ursprungsdaten werden automatisch oder auf andere Art und Weise neue Daten berechnet. Die neuen Daten legen ein neues Layout fest, das hinsichtlich der Geometrie einer mit den Ursprungsdaten hergestellten oder herstellbaren Maske ähnlicher als dem Ursprungs-Layout ist.

Beispielsweise lassen sich die neuen Daten durch Nachbildung der Verfahrensschritte beim Herstellen der Maske berechnen. lässt sich jedoch auch das Verfahren gemäß erstem Aspekt bzw. gemäß einer der genannten Weiterbildungen und Ausgestaltungen einsetzen, um die neuen Daten festzulegen.

Es ist Aufgabe des zweiten Aspekts der Erfindung, zum Erzeugen von optimierten Masken-Layout-Daten für Fotomasken ein einfaches Verfahren anzugeben. Weiterhin sollen eine zugehörige Vorrichtung und ein zugehöriges Programm angegeben werden.

Die Erfindung gemäß zweitem Aspekt geht von der Überlegung aus, dass das Berücksichtigen des Einflusses des Herstellungsprozesses der Maske nur ein Teilschritt auf dem Weg zum Festlegen von endgültigen Masken-Layout-Daten ist, die dann tatsächlich für die Maskenherstellung verwendet werden. Die durch den Herstellungsprozess auftretenden Veränderungen erfordern nämlich ihrerseits eine Veränderung des Ursprungs-Layouts in einem korrigierten Layout. Diese Änderungen wurden bisher manuell durchgeführt, lassen sich jedoch auch automa-tisieren.

Beim erfindungsgemäßen Verfahren gemäß zweitem Aspekt werden ausgehend von den neuen Daten automatisch korrigierte Daten so festgelegt, dass eine mit den korrigierten Daten hergestellte oder herstellbare korrigierte Maske hinsichtlich der Geometrie dem Ursprungs-Layout ähnlicher als einer mit den Ursprungdaten hergestellten oder herstellbaren Maske ist. Somit wird das Ursprungs-Layout als Ziel des Herstellungsprozesses der Maske betrachtet. Die Bezugnahme auf das Ursprungs-Layout gestatten es, einfache Kriterien für die automatische Korrektur festzulegen.

Alternativ oder kumulativ werden beim Verfahren, gemäß zweitem Aspekt die korrigierten Daten so festgelegt, dass die mit den korrigierten Daten hergestellte oder herstellbare Maske bessere lithografische Abbildungseigenschaften als eine mit den Ursprungsdaten hergestellte oder herstellbare Maske hat. Die lithografischen Abbildungseigenschaften sind für die erreichbaren Strukturbreiten bei der Waferbelichtung von grundlegender Bedeutung. Durch die verbesserte Abbildung mit einer aus den optimierten Masken-Layout-Daten hergestellten Maske kann die Ausbeute der Chipproduktion erheblich gestelgert werden. Außerdem lassen sich so Chips größerer elektrischer Leistungsfähigkeit herstellen, z.B. hinsichtlich einer höheren Taktfrequenz oder eines niedrigeren Stromverbrauchs.

Ein Kriterium für die automatische Korrektur ist bei einer Weiterbildung das Verhältnis der dunklen Flächen und der hellen Flächen des Ursprungs-Layouts. Im korrigierten Layout soll dieses Verhältnis erhalten bleiben oder um einen vorgegebenen Wert geändert werden. Das Flächenverhältnis ist nämlich zunächst im der neuen Layout aufgrund der berücksichtigten Effekte verändert

Erfindungsgemäβ werden die korrigierten Layout-Daten aufgrund von Korrekturregeln berechnet, die auf Abweichungen in der Geometrie eines Layouts von einer nach diesem Layout-hergestellten oder einer ausgehend von diesem Layout unter Nachbildung des Herstellungsprozesses modellierten Maske beruhen. Durch die Berücksichtigung der Abweichungen in der Geometrie lassen sich bereits so viele Korrekturregeln festlegen, dass die Korrektur vollständig oder fast vollständig automatisiert werden kann.

Bei einer Ausgestaltung wird das oben im Zusammenhang mit dem Verkürzungswert angesprochene Verfahren zum. Festlegen der neuen Daten eingesetzt. Gemäß einer Korrekturregel wird dann abhängig vom Verkürzungswert für eine Bezugsstruktur an einer Position des Ursprungs-Layouts ein Verlängerungswert bestimmt. Abhängig vom Verlängerungswert wird anschließend die an der gleichen Position in dem korrigierten Layout liegende Struktur im Vergleich zu der an der gleichen Position in dem neuen Layout liegenden Struktur in Längsrichtung verlängert. Ziel ist es dabei, sich der durch das Ursprungs-Layout vorgegebenen Struktur an der gleichen Position anzunähern. Dies erfolgt beispielsweise in einem Iterationsverfahren. Jedoch lassen sich auch Näherungsvorschriften einsetzen. Ein Korrekturverfahren wird unten an Hand der Figur 8 erläutert

Erfindungsgemäβ wird das oben angesprochene Verfahren im Zusammenhang mit dem Radius- bzw. Krümmungswert eingesetzt. Gemäß einer weiteren Korrekturregel wird dann abhängig vom Radius- oder Krümmungswert für eine Bezugsstruktur an einer Position des Ursprungs-Layout ein Verlängerungswert bestimmt. Abhängig vom Verlängerungswert wird anschließend die an der gleichen Position in dem korrigierten Layout liegende Struktur im Vergleich zu der an der gleichen Position in dem neuen Layout liegenden Struktur in Längsrichtung und/oder in Querrichtung verlängert. Bei dieser Ausgestaltung werden Verkürzungen, die durch das Abrunden der Ecken hervorgerufen werden, wieder ausgeglichen

Erfindungsgemäβ wird gemäß einer weiteren Korrekturregel abhängig vom Einengungswert für eine Bezugsstruktur an einer Position des Ursprungs-Layout ein Verbreiterungswert bestimmt. Zum Ermitteln des Einengungswertes wird die oben genannte Weiterbildung des Verfahrens gemäß erstem Aspekt der Erfindung eingesetzt. Abhängig vom Verbreitungswert wird dann die an der gleichen Position in dem korrigierten Layout liegende Struktur im Vergleich zu der an der gleichen Position in dem neuen Layout liegenden Struktur quer zur Längsrichtung zumindest abschnittsweise verbreitert. Durch diese Maßnahme wird trotz des "Peanuts"-Effekts erreicht, dass die korrigierte Maske eine Struktur mit gleichbleibender oder beabsichtigter Breite enthält.

Neben den genannten Ausgestaltungen werden auch andere Korrekturregeln zur Korrektur der Auswirkungen anderer Effekte eingesetzt. Dabei werden jedes Mal einfache geometrische Zusammenhänge genutzt.

Das Verlängern und/oder das Verbreitern wird bei einer Weiterbildung unter Beibehaltung der Form der Struktur in der neuen Maske ausgeführt. Alternativ lassen sich jedoch beim Verlängern oder Verbreitern auch einfache Strukturen anstückeln. Sollen beispielsweise Abrundungen korrigiert werden, so werden links und rechts einer Mittelachse kleine Quadrate an die Struktur der Ursprungs-Maske angesetzt, um die korrigierte Struktur zu erhalten. Die Struktur erhält damit eine serifenförmige Ausformung, wie sie bisher von OPC-Verfahren bekannt ist (Optical Proximity Correction - Korrektur nachbarschaftsinduzierter Beugungseffekte). Bekannte OPC-Verfahren berücksichtigen insbesondere den Belichtungsprozess des Wafers. Beim erfindungsgemäßen Verfahren werden dagegen im Wesentlichen die Effekte berücksichtigt, die durch den Maskenschreiber und den Maskenherstellungsprozess hervorgerufen werden.

Eine Vorrichtung, insbesondere eine Datenverarbeitungsanlage, ist zum Erzeugen von Masken-Layout-Daten für die Lithografiesimulation oder zum -erzeugen von optimierten Masken-Layout-Daten für Fotomasken eingerichtet. Eingesetzt werden jedoch auch Schaltungsanordnungen oder eine Spezial-Hardware in einer Datenverarbeitungsanlage. Die Vorrichtung ist so aufgebaut, dass beim Betrieb die Verfahrensschritte nach einem der Verfahren gemäß erstem Aspekt oder gemäß zweiten Aspekt bzw. gemäß deren Weiterbildungen ausgeführt werden. Damit gelten die oben genannten technischen Wirkungen auch für die Vorrichtung.

Ein Programm weist eine durch eine Datenverarbeitungsanlage ausführbaren Befehlsfolge auf. Beim Ausführen der Befehlsfolge werden die Verfahrensschritte gemäß erstem Aspekt oder gemäß zweitem Aspekt bzw. gemäß einer Weiterbildung eines dieser Aspekte ausgeführt. Das Programm befindet sich beispielsweise in einem RAM-Baustein (Random Access Memory), in einem programmierbaren Speicherbaustein, auf einer Diskette oder auf einer Kompaktdisc, kurz CD genannt.

Im folgenden werden Ausführungsbeispiele der Erfindung an Hand der beiliegenden Zeichnungen erläutert. Darin zeigen:
- Figur 1: eine Prinzipdarstellung Wafer-Lithografie und Lithografiesimulation sowie Verfahrensschritte zum Erzeugen der Layout-Daten für eine Lithografie- Maske,
- Figur 2: die Effekte "Linienverkürzung" und "Eckenabrundung" an Hand von Strukturen in der Mitte eines Ur- sprungs-Layouts,
- Figur 3: den Effekt einer verstärkten "Linienverkürzung" am Rand einer Struktur eines Ursprungs-Layouts,
- Figur 4: den Effekt einer verringerten "Linienverkürzung" aufgrund einer benachbarten Struktur,
- Figur 5: den Effekt der "Eckenabrundung" bei unregelmäßig geränderten Strukturen,
- Figur 6: den Effekt der "Eckenabrundung" bei einer dunklen Struktur, die eine helle Struktur umgibt,
- Figur: 7 den sogenannten "Peanuts"-Effekt, und
- Figur 8: eine Ursprungs-Maske sowie eine daraus berechnete und bezüglich des Effektes der Linienverkürzung korrigierte Maske.

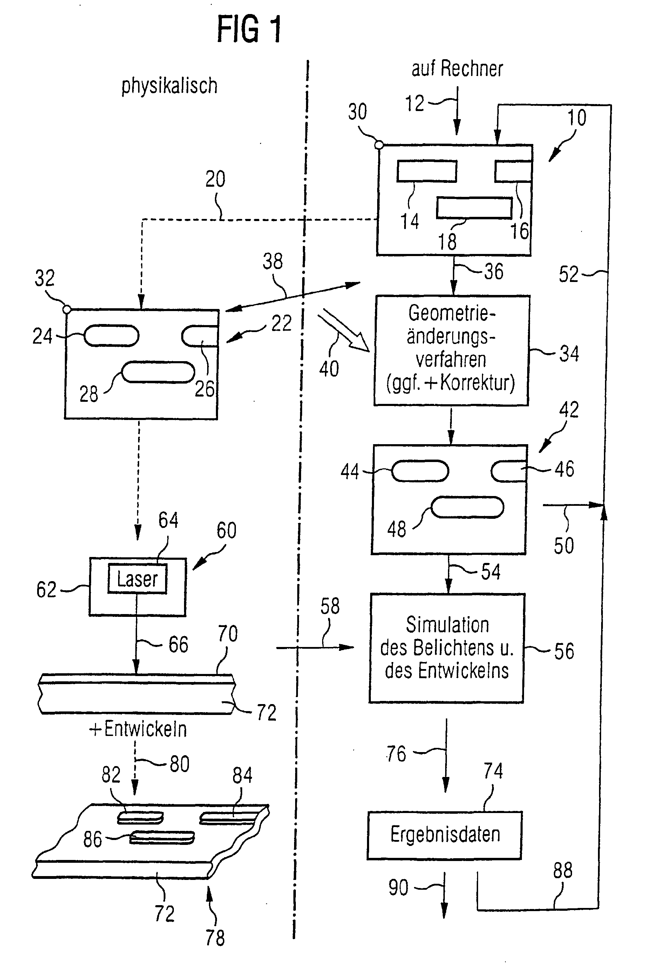

Figur 1 zeigt eine Prinzipdarstellung der Wafer-Lithografie und der Lithografiesimulation sowie die Verfahrensschritte zum Erzeugen der Layout-Daten für eine bei der Herstellung von integrierten Schaltkreisen genutzten Photo-Maske. Es wird angenommen, dass ein Ursprungs-Layout 10 und dieses Layout 10 festlegende Ursprungs-Layout-Daten 12 vorgegeben worden sind. Das Datenformat ist zur Eingabe in ein Programm zur Simulation des Lithografieprozesses ausgehend von den Ursprungs-Layout-Daten geeignet. Solche Programme sind beispielsweise das Programm "Solid-C" der Firma Sigma-C oder das Programm "Prolith" der Firma Finle. Die Daten 12 werden beispielsweise durch eine vorgelagerte Entwicklungsabteilung abhängig von den elektrischen Eigenschaften des Schaltkreises vorgegeben. Ein in einem idealen Herstellungsprozess gemäß Ursprungs-Layout 10 hergestellter integrierter Schaltkreis würde somit den elektrischen Anforderungen genügen. Jedoch treten bei einem realen Herstellungsprozess bereits bei der Herstellung einer Maske ausgehend vom der Ursprungs-Layout 10 Abweichungen auf.

Das Ursprungs-Layout 10 enthält drei rechteckförmige dunkle Strukturen 14, 16 und 18. Ein Pfeil 20 symbolisiert den Herstellungsprozess einer Maske ausgehend von den Ursprungs-Layout-Daten 12 der Ursprungs-Maske 10. Es entsteht eine Maske 22 mit drei dunklen Strukturen 24, 26 und 28, deren Breite jeweils z.B. 100 Nanometer beträgt. Die Strukturen 24, 26 und 28 liegen in dieser Reihenfolge in der Maske 22 an der gleichen Position wie die Strukturen 14, 16 und 18 in dem Ursprungs-Layout 10. Als Bezugspunkt lässt sich beispielsweise die linke obere Ecke 30 des Ursprungs-Layouts 10 und die linke obere Ecke 32 der Maske 22 verwenden.

Da jedoch das ursprungs-Layout 10 noch zu korrigieren ist, wird zunächst kein Herstellungsprozess 20 ausgeführt, um Kosten zu sparen. Anstelle des Herstellungsprozesses 20 wird ein Geometrieänderungs-Verfahren 34 ausgeführt, um die Einflüsse des Herstellungsprozesses der Maske zu berücksichtigen. Das Geometrieänderungs-Verfahren 34 ist beispielsweise in einem Programm für eine Datenverarbeitungsanlage hinterlegt. Als Eingaben für das Geometrieänderungs-Verfahren 34 dienen zum einen die Ursprungs-Layout-Daten 12 des Ursprungs-Layouts 10, siehe Pfeil 36. Beim Erstellen des Programms zur Realisierung des Geometrieänderungs-Verfahrens wurden außerdem Regeln im Programm hinterlegt, die allgemeine Änderungen der Geometrie bei der Herstellung einer Maske im Vergleich zum Ursprungs-Layout berücksichtigen, z.B. die Abrundung der Ecken bei der Herstellung der Maske 22, siehe Pfeile 38 und 40. Beispiele für solche Abweichungen sind folgende Effekte:
- Linienverkürzung,
- Einengungen einer langgestreckten Struktur in bestimmten Abschnitten, sogenannter "Peanuts"-Effekt,
- Abrundungen der Ecken, und
- CD-Linearität (Critical Dimension).

Beim Ausführen des Geometrieänderungs-Verfahren 34 werden die Abweichungen aufgrund der vorgegebenen Regeln berechnet. Die Regeln berücksichtigen die Ausdehnung und die Fläche der jeweiligen bearbeiteten Struktur 14, 16 bzw. 18 sowie den Einfluss benachbarter Strukturen 16 bis 18.

Ergebnis der Ausführung des Geometrieänderungs-Verfahrens sind Layout-Daten eines neuen Masken-Layouts 42, das dunkle Strukturen 44, 46 und 48 enthält, die in dieser Reihenfolge den Strukturen 14, 16 und 18 entsprechen. "Entsprechen" bedeutet in diesem Zusammenhang, dass eine Struktur in dem Ursprungs-Layout 10 an der gleichen Position liegt, wie die entsprechende Struktur in dem neuen Masken-Layout 42. Die Strukturen 44, 46 und 48 haben beispielsweise abgerundete Ecken und sind im Vergleich zu den Strukturen 14, 16 bzw. 18 verkürzt. Diese Linienverkürzung wird unten an Hand der Figur 2 bis 4 noch näher erläutert. Die Strukturen 44, 46 und 48 haben den Strukturen 24, 26 und 28 der Maske 22 sehr ähnliche Formen.

Beim ersten Ausführungsbeispiel wird das neue Masken-Layout 42 manuell korrigiert, um den Anforderungen der vorgelagerten Entwicklungsabteilung besser gerecht zu werden, vgl. Pfeile 50 und 52. Korrigierte Layout-Daten werden anschließend anstelle der Layout-Daten 12 des Ursprungs-Layout 10 verwendet. Durch einfache oder mehrfache Iteration entsteht anstelle des neuen Masken-Layouts 42 ein bzw. mehrere weitere neue Masken-Layouts. Die Daten des letzten neuen Masken-Layouts werden für die Simulation des Belichtens und des Entwickeins bei der Bearbeitung eines Wafers eingesetzt werden, siehe Pfeil 54 und Verfahrensschritt 56. Zur Simulation wird beispielsweise eines der bereits genannten Programm "Solid-C" und "Prolith" eingesetzt.

Vor der Simulation müssen in das Programm Parameter eingegeben werden, die einen Belichtungsprozess 60 und einen Entwickluhgsprozess der Waferbearbeitung charakterisieren. Der Belichtungsprozess 60 würde mit einer Belichtungsvorrichtung 62 durchgeführt werden, die sich zum Zeitpunkt der Simulation 56 noch im Entwicklungsstadium befinden kann. In diesem Fall sind anstelle von tatsächlichen Parametern die als Entwicklungsziele gesetzten Parameter einzugeben. Die Belichtungsvorrichtung 62 enthält beispielsweise eine Lasereinheit 64 zum Erzeugen eines Laserstrahls 66, der die Strukturen auf der Maske mittels einer Optik, meist verkleinert, auf eine mit einer Fotolackschicht 70 beschichtete Siliziumscheibe 72 (Wafer) abbilden. Bei der Simulation 56 werden die Verfahrensschritte des Belichtungsprozesses 60 und des Entwicklungsprozesses des Fotolacks nachgebildet, wobei Berechnungen mit Hilfe von Gleichungen ausgeführt werden, die die ablaufenden physikalischen Prozesse beschreiben

Am Ende der Simulation 56 werden Ergebnisdaten 74 ausgegeben, siehe Pfeil 76. Die Ergebnisdaten repräsentieren ein Lackmuster, das im Wesentlichen einem Lackmuster 78 entspricht, wie es mit Hilfe der Belichtungsvorrichtung 62 und des Entwicklungsprozesses tatsächlich hergestellt werden könnte, siehe Pfeil 80. Auf der Siliziumscheibe 72 sind langgestreckte Fotolackstrukturen 82, 84 und 86 verblieben, die in dieser Reihenfolge den Strukturen 14, 16 und 18 entsprechen.

Ausgehend von den Ergebnisdaten 74 sind oft weitere Korrekturen der Layout-Daten erforderlich, siehe Pfeile 88 und 52. Nach einer oder mehreren Iterationen werden Ergebnisdaten erzeugt, die für die Simulation weiterer Verfahrensschritte bei der Herstellung eines integrierten Schaltkreises geeignet sind, siehe Pfeil 90. Beispielsweise wird anschließend das Ätzen der Siliziumscheibe 72 simuliert.

Bei einem zweiten Ausführungsbeispiel wird im Rahmen des Geometrieänderungs-Verfahrens auch die Korrektur automatisch durchgeführt. Beispielsweise werden bei der Korrektur:
- Linienverkürzungen durch Verlängerung der betreffenden Strukturen beseitigt,
- Abrundungen von Ecken durch "Anstückeln" von Korrekturflächen vermieden, und
- Einengungen aufgrund des "Peanuts"-Effektes wieder verbreitert.

Beim Ausführen des Geometrieänderungs-Verfahren 34 werden beim zweiten Ausführungsbeispiel automatisch mehrere Iterationen durchgeführt, siehe Pfeile 50 bis 52. Die automatische Korrektur wird unten an Hand der Figur 8 näher erläutert.

Figur 2 zeigt die Effekte "Linienverkürzung" und "Eckenabrundung" an Hand von Strukturen 100, 102 und 104 eines Ursprungs-Layouts 110 und diesen Strukturen entsprechenden Strukturen 120, 122 und 124 eines neuen Masken-Layouts 130. Eine gestrichelte Linie zeigt den Wert x=0, an dem die zueinander parallelen Strukturen 100, 102 und 104 beginnen. Punkte 132 und 134 verdeutlichen, dass sich an die gezeigten Strunkturen 100, 102 und 104 oben und unten weitere parallele Strukturen anschließen. Punkte 136 und 138 verdeutlichen den selben Sachverhalt für die Strukturen 120, 122 und 124. Das neue Masken-Layout 130 wurde unter Verwendung des Geometrieänderungs-Verfahren 34 aus den Layout-Daten des Ursprungs-Layouts 110 erzeugt, wobei Einflüsse des Herstellungsprozesses für reale Masken berücksichtigt worden sind. Somit ähnelt das neue Masken-Layout 130 einer mit Hilfe des Ursprungs-Layouts 110 hergestellten Maske. Linien 140, 142 und 144 zeigen in dem neuen Masken-Layout 130 den ursprünglichen Verlauf der Strukturen 100, 102 und 104. Eine gestrichelte Linie zeigt wieder den Wert x=0.

Die Linienverkürzung ist für die drei parallel zueinander im gleichen Abstand angeordneten Strukturen 120, 122 und 124 gleich, so dass im folgenden nur die Verkürzung und die Eckenabrundung für die Struktur 122 erläutert wird. Die Struktur 122 ist im Vergleich zur Struktur 102 an dem einen Ende um einem Differenzwert D1 verkürzt, welchem eine Strecke 150 entspricht. Durch die Verkürzung wird der Einfluss des Herstellungsprozesses beim Herstellen einer Maske aus den Layout-Daten des Ursprungs-Layouts 110 berücksichtigt. Außerdem wurden die in Figur 2 gezeigten Enden der Strukturen 120, 122 und 124 abgerundet, um den Einfluss des Herstellungsprozesses zu berücksichtigen. Beim Ausführen des Geometrieänderungs-Verfahrens 34 wird selbständig ein Krümmungsradius für die Abrundungen ermittelt, der, der in diesem Ausführungsbeispiel, der halben Strukturbreite 152 entspricht.

Figur 3 zeigt den Effekt einer verstärkten "Linienverkürzung" am Rand einer Struktur eines Ursprungs-Layouts 170 im Vergleich zu einem neuen Masken-Layout 190. Der Effekt wird an Hand von Strukturen 160, 162 und 164 des Ursprungs-Layouts 170 und diesen Strukturen entsprechenden Strukturen 180, 182 und 184 des neuen Masken-Layouts 190 erläutert. Eine gestrichelte Linie zeigt den Wert x=0, an dem die zueinander parallelen Strukturen 160, 162 und 164 beginnen. Punkte 192 verdeutlichen, dass sich an die gezeigten Strukturen 160, 162 und 164 nach unten weitere parallele Strukturen anschließen. Punkte 194 verdeutlichen den selben Sachverhalt für die Strukturen 180, 182 und 184. Nach oben hin schließen sich keine Strukturen an die Strukturen 160, 162 und 164 bzw. 180, 182 und 184 an. Das neue Masken-Layout 190 wurde unter Verwendung des Geometrieänderungs-Verfahren 34 aus den Layout-Daten des Ursprungs-Layouts 170 erzeugt, wobei Einflüsse des Herstellungsprozesses für reale Masken berücksichtigt worden sind. Somit ähnelt das neue Masken-Layout 190 einer mit Hilfe des Ursprungs-Layouts 170 hergestellten Maske. Linien 200, 202 und 204 zeigen in dem neuen Masken-Layout 190 den ursprünglichen Verlauf der Strukturen 160, 162 und 164. Eine gestrichelte Linie zeigt wieder den Wert x=0.

Die Linienverkürzung ist für die Struktur 180 am größten. Für die beiden Strukturen 182 und 184 ist die Linienverkürzung näherungsweise gleich. Die Struktur 182 bzw. 184 ist im Vergleich zur Struktur 162 bzw. 164 an dem einen Ende um einem Differenzwert D2 verkürzt, welchem eine Strecke 210 entspricht. Der Differenzwert D2 hat in etwa denselben Wert wie der Differenzwert D1. Die Struktur 180 ist dagegen im Vergleich zur Struktur 160 um einen Differenzwert verkürzt, der größer als der Differenzwert D3 ist, siehe Strecke D3. Durch die Verkürzung wird der Einfluss des Herstellungsprozesses beim Herstellen einer Maske aus den Layout-Daten des Ursprungs-Layouts 110 berücksichtige. Insbesondere zeigt die stärkere Verkürzung der Struktur 150, dass oberhalb dieser Struktur keine weitern Strukturen angeordnet sind. Außerdem wurden die in Figur 3 gezeigten Enden der Strukturen 180, 182 und 184 abgerundet, um den Einfluss des Herstellungsprozesses zu berücksichtigen. Beim Ausrühren des Geometrieänderungs-Verfahrens 34 wird selbständig ein Krümmungsradius für die Abrundungen ermittelt, der, in diesem Ausführungsbeispiel, der halben Strukturbreite 212 entspricht.

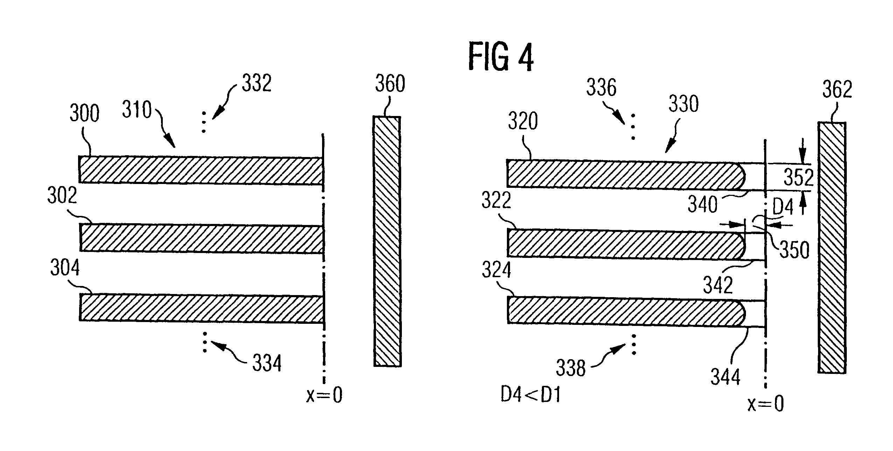

Figur 4 zeigt den Effekt einer verringerten "Linienverkürzung" aufgrund einer benachbarten Struktur 360 bzw. 362 an Hand von Strukturen 300, 302 und 304 eines Ursprungs-Layouts 310 und diesen Strukturen entsprechenden Strukturen 320, 322 und 324 eines neuen Masken-Layouts 330. Eine gestrichelte Linie zeigt den Wert x=0, an dem die zueinander parallelen Strukturen 300, 302 und 304 beginnen. Punkte 332 und 334 verdeutlichen, dass sich an die gezeigten Strukturen 300, 302 und 304 oben und unten weitere parallele Strukturen anschließen. Punkte 336 und 338 verdeutlichen den selben Sachverhalt für die Strukturen 320, 322 und 324. Die Struktur 360 liegt quer zu den Strukturen 300, 302 und 304 mit einen Abstand zum Beginn dieser Strukturen, der dem Abstand benachbarter Strukturen 300, 302 und 304 entspricht. Die Struktur 362 liegt quer zu den Strukturen 320, 322 und 324 mit einen Abstand zum Beginn dieser Strukturen, der dem Abstand benachbarter Strukturen 320, 322 und 324 entspricht.

Das neue Masken-Layout 330 wurde unter Verwendung des Geometrieänderungs-Verfahren 34 aus den Layout-Daten des Ursprungs-Layouts 310 erzeugt, wobei Einflüsse des Herstellungsprozesses für reale Masken berücksichtigt worden sind. Somit ähnelt das neue Masken-Layout 330 einer mit Hilfe des Ursprungs-Layouts 310 hergestellten Maske. Linien 340, 342 und 344 zeigen in dem neuen Masken-Layout 330 den ursprünglichen Verlauf der Strukturen 300, 302 und 304. Eine gestrichelte Linie zeigt wieder den Wert x=0.

Die Linienverkürzung ist für die drei parallel zueinander im gleichen Abstand angeordneten Strukturen 120, 122 und 124 gleich, so dass im folgenden nur die Verkürzung und die Eckenabrundung für die Struktur 322 erläutert wird. Die Struktur 322 ist im Vergleich zur Struktur 302 an dem einen Ende um einem Differenzwert D4 verkürzt, welchem eine Strecke 350 entspricht. Durch die Verkürzung wird der Einfluss des Herstellungsprozesses beim Herstellen einer Maske aus den Layout-Daten des Ursprungs-Layouts 110 berücksichtigt. Aufgrund der Struktur 360 bzw. 362 ist der Differenzwert D4 kleiner als der Differenzwert D1 bzw. D2, siehe Figur 2 bzw. 3.

Außerdem wurden die in Figur 2 gezeigten Enden der Strukturen 120, 122 und 124 abgerundet, um den Einfluss des Herstellungsprozesses zu berücksichtigen. Beim Ausführen des Geometrieänderungs-Verfahrens 34 wird selbständig ein Krümmungsradius für die Abrundungen ermittelt, der, in diesem Ausführungsbeispiel, der halben Strukturbreite 152 entspricht.

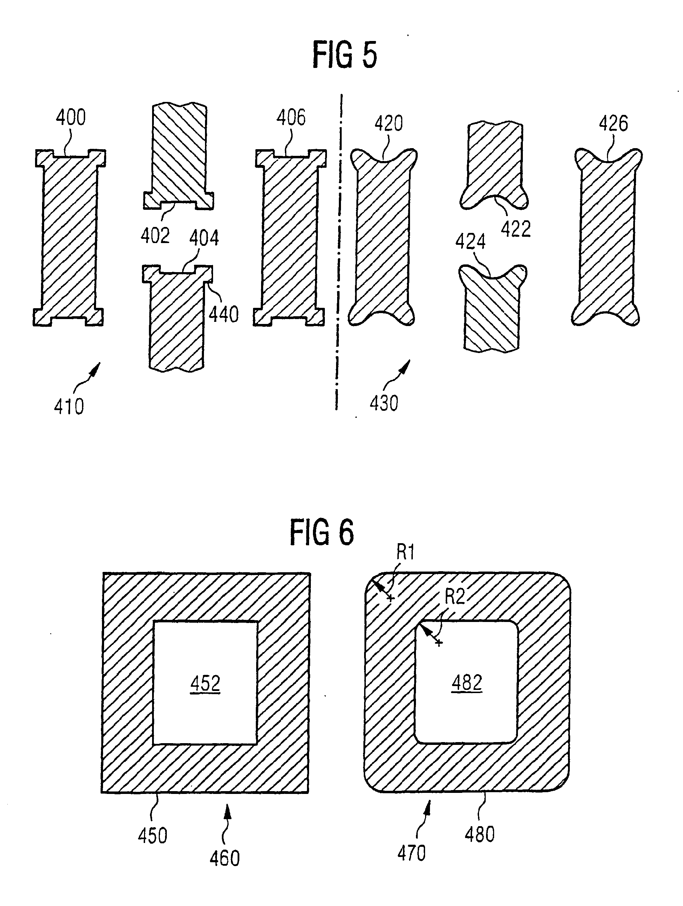

Figur 5 zeigt den Effekt der "Eckenabrundung" bei unregelmäßig geränderten Strukturen 400 bis 406 eines Ursprungs-Layouts 410 im Vergleich zu Strukturen 420 bis 426 eines neuen Layouts 430, das mit Hilfe des Geometrieänderungs-Verfahrens 34 berechnet worden ist. Die Strukturen 400 bis 406 haben an den Ecken sogenannte Serifen, siehe z.B. eine Serife 440. Die Serifen wurden in einem OPC-Verfahren an ursprünglich rechteckige Strukturen angefügt. In den Strukturen 420 bis 426 treten Verrundungen im Bereich der Ecken auf.

Figur 6 zeigt den Effekt der "Eckenabrundung" bei einer dunklen Struktur 450, die eine helle rechteckförmige helle Struktur 452 umgibt. Beide Strukturen gehören zu einem Ursprungs-Layout 460. Aus dem Ursprungs-Layout wurde mit Hilfe des Geometrieänderungs-Verfahrens 34 ein neues Masken-Layout 470 berechnet, das den Strukturen 450 bzw. 452 entsprechende Strukturen 480 bzw. 482 enthält. Die äußeren Ecken der dunklen Struktur 480 sind mit einem Radius R1 abgerundet, der größer als ein Radius R2 ist, mit welchen die inneren Ecken der Struktur 480 abgerundet sind.

Figur 7 zeigt den sogenannten "Peanuts"-Effekt an Hand von rechteckförmigen Strukturen 490 bis 496 eines Ursprungs-Layouts 500 im Vergleich zu Strukturen 510 bis 516 eines neuen Masken-Layouts 520, das mit Hilfe des Geometrieänderungs-Verfahrens 34 aus dem Ursprungs-Layout 500 berechnet worden ist. Die Strukturen 510 bis 516 sind in Mittelabschnitten Eingeengt, siehe z.B. Verengung 522, Die Verengungen sind auf das Fehlen nah benachbarter Strukturen zurückzuführen.

Figur 8 zeigt ein Ursprungs-Layout 600 und ein neues Masken-Layout 602, dessen Masken-Daten durch iterative Anwendung des Geometrieänderungs-Verfahrens 34 berechnet worden sind. Bei dieser Berechnung wurde zunächst die Änderung von Strukturen des Ursprungs-Layouts 600, z.B. der Struktur 604, aufgrund des Herstellungsverfahrens berechnet. Die Änderungen führten zu einem ersten neuen Masken-Layout (nicht dargestellt). Anschließend wurden die Layout-Daten ausgehend von dem ersten neuen Masken-Layout korrigiert. Das neue Masken-Layout 602 wurde danach durch nochmaliges Ausführen des Geometrieänderungs-Verfahrens 34 aus den korrigierten Layout-Daten berechnet.

Die Korrektur der Layout-Daten erfolgte so, dass die Flächen der dunklen Strukturen 604 und 606 gleich sind. Dies ist möglich, wenn die Rundungen der Struktur 606 über einen Rahmen 608 hinausstehen, der die ursprüngliche Lage der der Struktur 606 entsprechenden Struktur 204 verdeutlicht.

Zur Herstellung einer Maske werden die korrigierten Daten eingesetzt. Die Ecken der Strukturen im korrigierten Layout sind nicht verrundet.

### Bezugszeichenliste

- 10: Ursprungs-Layout
- 12: Ursprungs-Layout-Daten
- 14, 16, 18: dunkle Struktur
- 20: Herstellungsprozess
- 22: Maske
- 24, 26, 28: dunkle Struktur
- 30, 32: linke obere Ecke
- 34: Geometrieänderungs-Verfahren
- 36, 38, 40: Pfeil
- 42: neues Maske-Layout
- 44, 46, 48: dunkle Struktur
- 50, 52, 54: Pfeil
- 56: Simulation
- 58: Parameter
- 60: Belichtungsprozess
- 62: Belichtungsvorrichtung
- 64: Lasereinheit
- 66: Laserstrahl
- 70: Fotolackschicht
- 72: Siliziumscheibe
- 74: Ergebnisdaten
- 76: Pfeil
- 78: Lackstrukturen
- 80: Pfeil
- 82, 84, 86: Fotolackstruktur
- 88, 90: Pfeil
- 100, 102, 104: Struktur
- 110: Ursprungsmasken-Layout
- 120, 122, 124: Szrukzur
- 130: neues Masken-Layout
- 132 bis 138: Punkte
- 140, 142, 144: Linie
- 150: Strecke
- 152: Strukturbreite
- 160, 162, 164: Struktur
- 170: Ursprungs-Layout
- 180, 182, 184: Struktur
- 190: neues Masken-Layout
- 192, 194: dunkle
- 200, 202, 204: Linie
- 210: Strecke
- 212: Strukturbreite
- 214: Strecke
- 302, 304, 306: Struktur
- 310: Ursprungs-Layout
- 320, 322, 324: Struktur
- 330: neues Masken-Layout
- 332 bis 338: Punkte
- 340, 342, 344: Linie
- 350: Strecke
- 352: Strukturbreite
- 360, 362: benachbarte Struktur
- 400 bis 406: Struktur
- 410: Ursprungs-Layout
- 420 bis 426: Struktur
- 430: neues Masken-Layout
- 440: Serife
- 450: dunkle Struktur
- 452: helle Struktur
- 460: Ursprungs-Layout
- 470: neues Masken-Layout
- 490 bis 496: Strecke
- 500: Ursprungs-Layout
- 510 bis 516: Struktur
- 520: neues Masken-Layout
- 522: Verengung
- 480, 482: Struktur
- R1, R2: Radius
- 600: Ursprungs-Maske
- 602: neues Masken-Layout
- 604, 606: Struktur
- 608: Rahmen
- D1 bis D4: Differenzwert

## Patentansprüche

1. Verfahren zum Erzeugen von Masken-Layout-Daten für die Lithografiesimulation,
bei dem Ursprungsdaten (12) vorgegeben werden, die ein Ursprungslayout (10) festlegen,
automatisch ausgehend von den Ursprungsdaten (12) neue Daten (54) berechnet werden, die ein neues Layout (42) festlegen,
und bei dem das neue Layout (42) hinsichtlich der Geometrie einer mit den Ursprungsdaten (12) hergestellten oder herstellbaren Maske (22) ähnlicher als dem Ursprungs-Layout (10) ist,
bei dem die neuen Daten (54) aufgrund von Regeln berechnet werden (34), die auf Abweichungen in der Geometrie eines Layouts von einer nach diesem Layout hergestellten oder einer ausgehend von diesem Layout unter Nachbildung der Schritte des Herstellungsprozesses modellierten Maske beruhen (38, 40), und
**dadurch gekennzeichnet ist, dass** die Regeln geometrische Berechnungsvorschriften zum Festlegen der Grenzen einer Struktur an einer Position des neuen Layouts (42) abhängig von der Länge und/oder der Fläche einer an der gleichen Position in dem Ursprungs-Layout (10) liegenden Bezugsstruktur und/oder abhängig vom Abstand der Bezugsstruktur zu benachbarten Strukturen enthalten.

2. Verfahren nach Anspruch 1, **dadurch gekennzeichnet, dass** gemäß einer Regel ein Verkürzungswert (150) für eine langgestreckte Bezugsstruktur (102) an einer Position des Ursprungs-Layouts (110) ermittelt wird, und dass abhängig vom Verkürzungswert (150) die an der gleichen Position in dem neuen Layout (130) liegende Struktur im Vergleich zur Bezugsstruktur (102) in Längsrichtung verkürzt wird.

3. Verfahren nach einem der vorhergehenden Ansprüche, **dadurch gekennzeichnet, dass** gemäß einer Regel eine eckige Bezugsstruktur (102) an einer Position des Ursprungs-Layouts (10) ermittelt wird,
dass mindestens ein Radius- oder Krümmungswert zum Abrunden einer Ecke ermittelt oder vorgegeben wird,
und dass abhängig vom Radius- oder Krümmungswert die an der gleichen Position in dem neuen Layout (130) liegende Struktur anstelle der Ecke einen abgerundeten Kantenverlauf hat.

4. Verfahren nach Anspruch 3, **dadurch gekennzeichnet, dass** bei einer Licht absorbierenden Struktur (480), die um eine Licht durchlässige Struktur (482) herum liegt, eine innere Ecke mit einem kleineren Radius (R2) abgerundet wird als eine äußere Ecke der Licht absorbierenden Struktur (480).

5. Verfahren nach einem der vorhergehenden Ansprüche, **dadurch gekennzeichnet, dass** gemäß einer Regel ein Einengungswert für eine langgestreckte Bezugsstruktur an einer Position des Ursprungs-Layouts ermittelt wird,
und dass abhängig vom Einengungswert die an der gleichen Position in dem neuen Layout liegende Struktur im Vergleich zur Bezugsstruktur zumindest abschnittsweise quer zur Längsrichtung eingeengt wird.

6. Verfahren zum Erzeugen von optimierten Masken-Layout-Daten für Fotomasken,
bei dem Ursprungsdaten (12) vorgegeben werden, die ein Ursprungs-Layout (10) festlegen,
ausgehend von den Ursprungsdaten (12) neue Daten (54) berechnet werden, die ein neues Layout (42) festlegen,
und bei dem das neue Layout (42) hinsichtlich der Geometrie einer mit den Ursprungsdaten (12) hergestellten oder herstellbaren Maske (22) ähnlicher als dem Ursprungs-Layout (10) ist,
wobei automatisch ausgehend von den neuen Daten korrigierte Daten eines korrigierten Layouts so festgelegt werden, dass eine mit den korrigierten Daten hergestellte oder herstellbare korrigierte Maske hinsichtlich der Geometrie dem Ursprungs-Layout (10) ähnlicher als einer mit den Ursprungsdaten (12) hergestellten oder herstellbaren Maske (22) ist,
**dadurch gekennzeichnet, dass** die korrigierten Daten aufgrund von Korrekturregeln berechnet werden (34), die auf Abweichungen in der Geometrie eines Layouts von einer nach diesem Layout hergestellten oder einer ausgehend von diesem Layout unter Nachbildung des Herstellungsprozesses modellierten Maske beruhen (38, 40); und
wobei gemäß einer Korrekturregel abhängig vom Radius- oder Krümmungswert für eine Bezugsstruktur an einer Position des Ursprungs-Layouts ein Verlängerungswert bestimmt wird,
und dass abhängig vom Verlängerungswert die an der gleichen Position in dem korrigierten Layout liegende Struktur im Vergleich zu der an der gleichen Position in dem neuen Layout liegenden Struktur in Längsrichtung verlängert und/oder in Querrichtung verbreitert wird.

7. Verfahren zum Erzeugen von optimierten Masken-Layout-Daten für Fotomasken,
bei dem Ursprungsdaten (12) vorgegeben werden, die ein Ursprungs-Layout (10) festlegen,
ausgehend von den Ursprungsdaten (12) neue Daten (54) berechnet werden, die ein neues Layout (42) festlegen,
und bei dem das neue Layout (42) hinsichtlich der Geometrie einer mit den Ursprungsdaten (12) hergestellten oder herstellbaren Maske (22) ähnlicher als dem Ursprungs-Layout (10) ist,
wobei automatisch ausgehend von den neuen Daten korrigierte Daten eines korrigierten Layouts so festgelegt werden, dass eine mit den korrigierten Daten hergestellte oder herstellbare korrigierte Maske hinsichtlich der Geometrie dem Ursprungs-Layout (10) ähnlicher als einer mit den Ursprungsdaten (12) hergestellten oder herstellbaren Maske (22) ist,
**dadurch gekennzeichnet, dass** die korrigierten Daten aufgrund von Korrekturregeln berechnet werden (34), die auf Abweichungen in der Geometrie eines Layouts von einer nach diesem Layout-hergestellten oder einer ausgehend von diesem Layout unter Nachbildung des Herstellungsprozesses modellierten Maske beruhen (38, 40); und
wobei gemäß einer Korrekturregel abhängig vom Einengungswert für eine Bezugsstruktur an einer Position des Ursprungs-Layouts ein Verbreiterungswert bestimmt wird,
und dass abhängig vom Verbreiterungswert die an der gleichen Position in dem korrigierten Layout liegende Struktur im Vergleich zu der an der gleichen Position in dem neuen Layout liegende Struktur quer zur Längsrichtung zumindest abschnittsweise verbreitert wird.

8. Verfahren zum Erzeugen von optimierten Masken-Layout-Daten für Fotomasken,
bei dem Ursprungsdaten (12) vorgegeben werden, die ein Ursprungs-Layout (10) festlegen,
wobei ein Geometrieänderungs-Verfahren (34) zum Erzeugen von optimierten Masken-Layout-Daten durchgeführt wird, welches die Einflüsse des Herstellungsprozesses einer Fotomaske berücksichtigt,
und welches als Eingaben die Ursprungsdaten (12) des Ursprungs-Layouts (10) und Korrekturregeln, die auf Abweichungen in der Geometrie eines Layouts von einer nach diesem Layout hergestellten Maske beruhen, aufweist,
wobei im Rahmen des Geometrieänderungs-Verfahrens (34) gemäß einer Korrekturregel abhängig vom Verkürzungswert für eine Bezugsstruktur an einer Position des Ursprungs-Layouts (10) automatisch ein Verlängerungswert bestimmt wird,
und abhängig vom Verlängerungswert eine der Bezugsstruktur in den optimierten Masken-Layout-Daten entsprechende Struktur in Längsrichtung verlängert wird.

9. Verfahren nach einem der Ansprüche 6 bis 7, **dadurch gekennzeichnet, dass** zum Ermitteln der neuen Daten (54) ein Verfahren nach einem der Ansprüche 1 bis 5 ausgeführt wird.

10. Verfahren nach einem der Ansprüche 6 bis 7, **dadurch gekennzeichnet, dass** das Verhältnis der dunklen Flächen und der hellen Flächen des Ursprungs-Layouts im korrigierten Layout erhalten bleibt oder um einen vorgegebenen Wert geändert wird.

## Claims

1. Method for generating mask layout data for lithography simulation,
wherein original data (12) which define an original layout (10) are specified,
new data (54) which define a new layout (42) are automatically calculated based on the original data (12), and wherein in terms of geometry the new layout (42) is more similar to a mask (22) which is produced or can be produced using the original data (12) than to the original layout (10),
wherein the new data (54) are calculated (34) on the basis of rules which are based (38, 40) on deviations in the geometry of a layout from a mask which is produced in accordance with this layout or a mask which is modelled based on this layout whilst simulating the steps of the production process, and
**characterised in that** the rules contain geometric calculation specifications for defining the boundaries of a structure at a position of the new layout (42) in dependence upon the length and/or area of a reference structure located at the same position in the original layout (10) and/or in dependence upon the distance from the reference structure to adjacent structures.

2. Method as claimed in Claim 1, **characterised in that** in accordance with a rule, a shortening value (150) is determined for an elongated reference structure (102) at a position of the original layout (110), and **in that** in dependence upon the shortening value (150) the structure located at the same position in the new layout (130) is shortened in the longitudinal direction compared with the reference structure (102).

3. Method as claimed in any one of the preceding claims, **characterised in that** in accordance with a rule, an angled reference structure (102) is determined at a position of the original layout (10),
**in that** at least one radius or curvature value is determined or specified for rounding off a corner,
and **in that** in dependence upon the radius or curvature value the structure located at the same position in the new layout (130) has a rounded-off edge profile instead of the corner.

4. Method as claimed in Claim 3, **characterised in that** in the case of a light-absorbing structure (480) which is located around a light-transmissive structure (482), an inner corner is rounded off with a smaller radius (R2) than an outer corner of the light-absorbing structure (480).

5. Method as claimed in any one of the preceding claims, **characterised in that** in accordance with a rule a narrowing value is determined for an elongated reference structure at a position of the original layout,
and **in that** in dependence upon the narrowing value the structure located at the same position in the new layout is narrowed at least in sections transversely with respect to the longitudinal direction compared with the reference structure.

6. Method for generating optimised mask layout data for photomasks,
wherein original data (12) which define an original layout (10) are specified,
new data (54) which define a new layout (42) are calculated based on the original data (12),
and wherein in terms of geometry the new layout (42) is more similar to a mask (22) which is produced or can be produced using the original data (12) than to the original layout (10),
wherein corrected data of a corrected layout are defined automatically based on the new data such that in terms of geometry a corrected mask which is produced or can be produced using the corrected data is more similar to the original layout (10) than to a mask (22) which is produced or can be produced using the original data (12),
**characterised in that** the corrected data are calculated (34) on the basis of correction rules which are based (38, 40) on deviations in the geometry of a layout from a mask which is produced in accordance with this layout or a mask which is modelled based on this layout whilst simulating the production process; and
wherein in accordance with a correction rule in dependence upon the radius or curvature value for a reference structure at a position of the original layout a lengthening value is determined,
and **in that** in dependence upon the lengthening value the structure located at the same position in the corrected layout is lengthened in the longitudinal direction and/or widened in the transverse direction compared with the structure located at the same position in the new layout.

7. Method for generating optimised mask layout data for photomasks,
wherein original data (12) which define an original layout (10) are specified,
new data (54) which define a new layout (42) are automatically calculated based on the original data (12),
and wherein in terms of geometry the new layout (42) is more similar to a mask (22) which is produced or can be produced using the original data (12) than to the original layout (10),
wherein corrected data of a corrected layout are defined automatically based on the new data such that in terms of geometry a corrected mask which is produced or can be produced using the corrected data is more similar to the original layout (10) than to a mask (22) which is produced or can be produced using the original data (12),
**characterised in that** the corrected data are calculated (34) on the basis of correction rules which are based (38, 40) on deviations in the geometry of a layout from a mask which is produced in accordance with this layout or a mask which is modelled based on this layout whilst simulating the production process; and
wherein in accordance with a correction rule in dependence upon the narrowing value for a reference structure at a position of the original layout a widening value is determined,
and **in that** in dependence upon the widening value the structure located at the same position in the corrected layout is widened at least in sections transversely with respect to the longitudinal direction compared with the structure located at the same position in the new layout.

8. Method for generating optimised mask layout data for photomasks,
wherein original data (12) which define an original layout (10) are specified,
wherein a geometry-changing method (34) for generating optimised mask layout data is implemented which takes into consideration the influences of the production process of a photomask,
and which comprises, as inputs, the original data (12) of the original layout (10) and correction rules which are based on deviations in the geometry of a layout from a mask produced in accordance with this layout,
wherein within the scope of the geometry-changing method (34) in accordance with a correction rule in dependence upon the shortening value for a reference structure at a position of the original layout (10) a lengthening value is automatically determined,
and in dependence upon the lengthening value a structure corresponding to the reference structure in the optimised mask layout data is lengthened in the longitudinal direction.

9. Method as claimed in any one of Claims 6 to 7, **characterised in that** in order to determine the new data (54) a method as claimed in any one of Claims 1 to 5 is implemented.

10. Method as claimed in any one of Claims 6 to 7, **characterised in that** the ratio of the dark areas and light areas of the original layout remains the same in the corrected layout or is changed by a specified value.

## Revendications

1. Procédé pour produire des données de tracé de masque pour la simulation lithographique,
dans lequel sont prédéfinies des données initiales (12) qui déterminent un tracé initial (10),
de nouvelles données (54) qui déterminent un nouveau tracé (12) sont calculées automatiquement à partir des données initiales (12),
et dans lequel, pour ce qui est de la géométrie, le nouveau tracé (42) ressemble plus à un masque (22) qui est produit ou qui peut être produit à l'aide des données initiales (12) qu'au tracé initial,
dans lequel les nouvelles données (54) sont calculées (34) à partir de règles qui reposent (38, 40) sur des écarts dans la géométrie d'un tracé par rapport à un masque produit selon ce tracé ou modélisé à partir de ce tracé en reproduisant les étapes de l'opération de production et
**caractérisé en ce que** les règles comportent des prescriptions de calcul géométrique pour déterminer les limites d'une structure à un endroit du nouveau tracé (42) en fonction de la longueur et/ou de la surface d'une structure de référence qui se trouve au même endroit dans le tracé initial (10) et/ou en fonction de la distance de la structure de référence par rapport à des structures voisines.

2. Procédé selon la revendication 1, **caractérisé en ce que** selon une règle une valeur de raccourcissement (150) pour une structure de référence (102) allongée est définie à un endroit du tracé initial (110) et que
en fonction de la valeur de raccourcissement (150) la structure qui se trouve au même endroit du nouveau tracé (130) est raccourcie en direction longitudinale par rapport à la structure de référence (102).

3. Procédé selon l'une des revendications précédentes, **caractérisé en ce que** selon une règle une structure de référence (102) angulaire est définie à un endroit du tracé initial (10)
qu'au moins une valeur de rayon ou de courbure est définie ou prédéfinie pour arrondir un coin et qu'en fonction de la valeur de rayon ou de courbure la structure qui se trouve au même endroit du nouveau tracé (130) a un tracé arrondi au lieu du coin.

4. Procédé selon la revendication 3, **caractérisé en ce que**, pour une structure (480) absorbant la lumière qui se trouve autour d'une structure (482) translucide, un coin intérieur est arrondi selon un rayon (R 2) inférieur à celui d'un coin extérieur de la structure (480) absorbant la lumière.

5. Procédé selon l'une des revendications précédentes, **caractérisé en ce que** selon une règle une valeur de rétrécissement pour une structure de référence allongée est définie à un endroit du tracé initial
et qu'en fonction de la valeur de rétrécissement la structure qui se trouve au même endroit du nouveau tracé est au moins par endroits rétrécie transversalement à la direction longitudinale par rapport à la structure de référence.

6. Procédé pour produire des données optimisées de tracé de masques pour des masques photographiques
dans lequel sont prédéfinies des données initiales (12) qui déterminent un tracé initial (10),
de nouvelles données (54) qui déterminent un nouveau tracé (42) sont calculées à partir des données initiales (12).
et dans lequel, pour ce qui est de la géométrie, le nouveau tracé (42) ressemble plus à un masque (22) qui est produit ou qui peut être produit à l'aide des données initiales (12) qu'au tracé initial,
des données corrigées d'un tracé corrigé sont alors automatiquement définies à partir des nouvelles données de telle manière qu'un masque corrigé qui est produit ou peut être produit à l'aide des données corrigées, pour ce qui est de la géométrie, ressemble plus au tracé initial (10) qu'à un masque qui est produit ou peut être produit à l'aide des données initiales (12),
**caractérisé en ce que** les données corrigées sont calculées (34) à partir de règles de correction qui reposent (38, 40) sur des écarts dans la géométrie d'un tracé par rapport à un masque produit selon ce tracé ou modélisé à partir de ce tracé en reproduisant l'opération de production,
une valeur d'allongement est alors déterminée, selon une règle de correction qui dépend de la valeur de rayon ou de correction, pour une structure de référence à un endroit du tracé initial,
et que la structure qui se trouve au même endroit dans le tracé corrigé est allongée, en fonction de la valeur d'allongement, en direction longitudinale et/ou élargie en direction transversale par rapport à la structure qui se trouve au même endroit dans le nouveau tracé.

7. Procédé pour produire des données optimisées de tracé de masque pour des masques photographiques,
dans lequel sont prédéfinies des données initiales (12) qui déterminent un tracé initial (10),
de nouvelles données (54) qui déterminent un nouveau tracé (42) sont calculées à partir des données initiales (12),
et dans lequel, pour ce qui est de la géométrie, le nouveau tracé (42) ressemble plus à un masque (22) qui est produit ou qui peut être produit à l'aide des données initiales (12) qu'au tracé initial,
des données corrigées d'un tracé corrigé sont alors automatiquement définies à partir des nouvelles données de telle manière qu'un masque corrigé qui est produit ou peut être produit à l'aide des données corrigées, pour ce qui est de la géométrie, ressemble plus au tracé initial (10) qu'à un masque qui est produit ou peut être produit à l'aide des données initiales (12),
**caractérisé en ce que** les données corrigées sont calculées (34) à partir de règles de correction qui reposent (38, 40) sur des écarts dans la géométrie d'un tracé par rapport à un masque produit selon ce tracé ou modélisé à partir de ce tracé en reproduisant l'opération de production, et
une valeur d'élargissement est alors déterminée selon une règle de correction en fonction de la valeur de rétrécissement pour une structure de référence à un endroit du tracé initial
et que la structure qui se trouve au même endroit dans le tracé corrigé est au moins par endroits élargie, en fonction de la valeur d'élargissement, en direction transversale par rapport à la structure qui se trouve au même endroit dans le nouveau tracé.

8. Procédé pour produire des données optimisées de tracé de masque pour des masques photographiques,
dans lequel sont prédéfinies des données initiales (12) qui déterminent un tracé initial (10),
un procédé de modification géométrique (34) destiné à produire des données optimisées de tracé de masque est alors exécuté, lequel prend en compte les effets de l'opération de fabrication d'un masque photographique
et dont les données fournies sont les données initiales (12) du tracé initial (10) et des règles de correction qui reposent sur des écarts dans la géométrie d'un tracé par rapport à un masque produit selon ce tracé,
une valeur d'allongement est alors déterminée, dans le cadre du procédé de modification géométrique (34), selon une valeur de correction qui dépend de la valeur de raccourcissement pour une structure de référence à un endroit du tracé initial (10),
et une structure qui correspond à la structure de référence dans les données de tracé de masque optimisées est allongée, en fonction de la valeur d'allongement, en direction longitudinale.

9. Procédé selon l'une des revendications 6 ou 7, **caractérisé en ce qu'**un procédé selon une des revendications 1 à 5 est exécuté pour définir les nouvelles données (54).

10. Procédé selon l'une des revendications 6 ou 7, **caractérisé en ce que** le rapport des surfaces sombres et des surfaces claires du tracé initial est conservé dans le tracé corrigé ou est modifié selon une valeur prédéfinie.
